Europäisches Patentamt

(19) European Patent Office

Office européen des brevets

(11) Numéro de publication : **0 047 199**
**B1**

(12) **FASCICULE DE BREVET EUROPÉEN**

(45) Date de publication du fascicule du brevet :
**17.10.84**

(51) Int. Cl.³ : **H 03 H 17/04**

(21) Numéro de dépôt : **81401312.4**

(22) Date de dépôt : **17.08.81**

(54) **Filtre numérique récursif de suréchantillonnage en arithmétique distribuée.**

(30) Priorité : **27.08.80 FR 8018579**

(43) Date de publication de la demande :
**10.03.82 Bulletin 82/10**

(45) Mention de la délivrance du brevet :
**17.10.84 Bulletin 84/42**

(84) Etats contractants désignés :
**DE GB NL SE**

(56) Documents cités :
**FR-A- 2 116 224**
**US-A- 3 777 130**
**IEEE TRANSACTIONS ON ACOUSTICS, SPEECH
AND SIGNAL PROCESSING, vol. ASSP-22, no. 4, aout
1974, NEW YORK (US) M. BELLANGER et al.: "Interpolation, Extrapolation, and Reduction of Computation Speed In Digital Filters", pages 231-235**

(73) Titulaire : **Petit, Jean-Pierre**
**16, Rue le Peletier**
**F-22220 Treguier (FR)**

**Maitre, Xavier**
**Route de Pennker Le Bourg**
**F-22300 Lannion (FR)**

(72) Inventeur : **Petit, Jean-Pierre**
**16, Rue le Peletier**
**F-22220 Treguier (FR)**
Inventeur : **Maitre, Xavier**
**Route de Pennker Le Bourg**
**F-22300 Lannion (FR)**

(74) Mandataire : **Mongrédien, André et al**
**c/o BREVATOME 25, rue de Ponthieu**
**F-75008 Paris (FR)**

## Description

La présente invention a pour objet un filtre numérique récursif de suréchantillonnage en arithmétique distribuée. Elle trouve une application d'une façon générale en traitement de signal et plus particulièrement en télécommunications.

Dans les systèmes de codage-décodage-filtrage de type MIC (Modulation par impulsions codées) fonctionnant par codage interpolatif et filtrage numérique, interviennent des filtres numériques de sous- et de suréchantillonnage. Il s'agit de filtres pour lesquels la fréquence d'échantillonnage des signaux d'entrée $f_E$ et celle des signaux de sortie $f_S$ ne sont pas identiques. Pour le souséchantillonnage on a $f_E > f_S$ et pour le suréchantillonnage $f_E < f_S$.

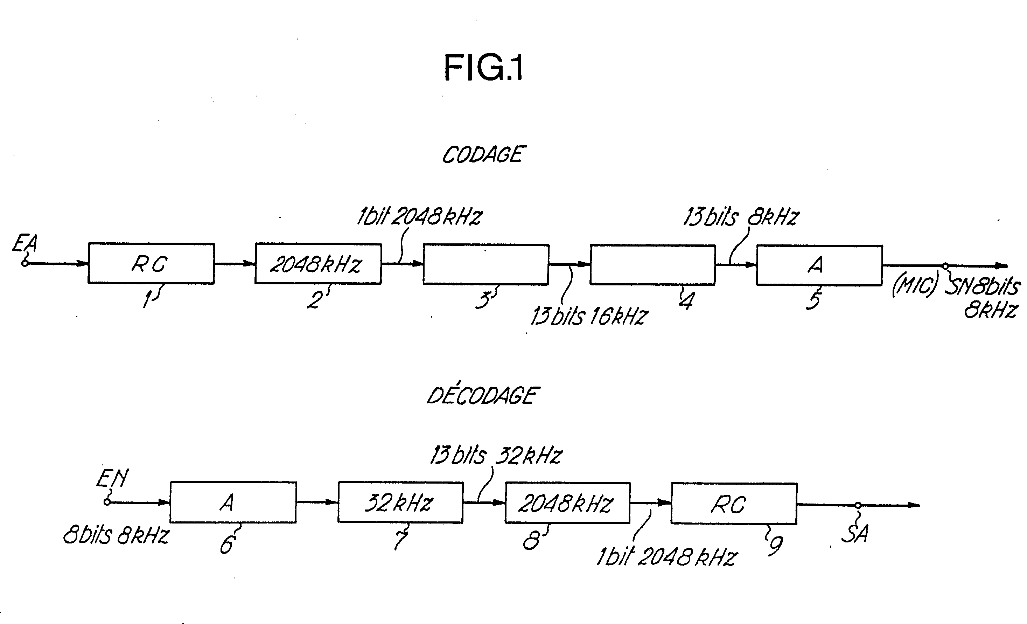

La figure 1 rappelle l'organisation de tels systèmes. Ils comprennent une chaîne de codage et une chaîne de décodage. La chaîne de codage est constituée par une entrée analogique EA, un filtre 1 de type RC, un codeur delta-sigma à double intégration 2 fonctionnant par exemple à 2 048 kHz et délivrant des signaux de 1 bit à 2 048 kHz, un filtre numérique de souséchantillonnage triangulaire 3 délivrant des signaux de 13 bits à 16 kHz, un filtre numérique de souséchantillonnage 4 délivrant des signaux de 13 bits à 8 kHz, un circuit 5 de compression de loi linéaire en loi A, dont la sortie numérique SN délivre des signaux de 8 bits à 8 kHz. De façon symétrique, la chaîne de décodage comprend une entrée numérique EN, un circuit 6 d'extension de la loi A vers la loi linéaire, un filtre numérique de suréchantillonnage 7 fonctionnant à 32 kHz et délivrant des signaux de 13 bits à 32 kHz, un décodeur delta-sigma à double intégration 8 fonctionnant à 2 048 kHz et délivrant des signaux de 1 bit à cette fréquence et enfin un filtre 9 de type RC dont la sortie SA délivre le signal analogique restitué. Naturellement, les valeurs numériques indiquées ne sont que des exemples.

La demande de brevet français n° 79 18862 déposée le 20.07.1979 et intitulée « Codeur delta-sigma à double intégration analogique et décodeur delta-sigma à double intégration numérique » décrit notamment les circuits 2 et 8.

Le cahier des charges relatif à de tels systèmes est contenu dans l'avis G712 du CCITT, livre orange, tome III-2, intitulé « Caractéristiques de qualité des voies MIC aux fréquences vocales ».

Des projets récents ont été lancés concernant des systèmes de ce genre devant répondre à un cahier des charges beaucoup plus sévère que celui de l'avis G712 en question, en particulier en ce qui concerne les filtres à l'émission et à la réception. Pour satisfaire aux gabarits appropriés à ces filtres, il est alors nécessaire de recourir à la technique du filtrage numérique dit récursif dans lequel les signaux de sortie du filtre sont réinjectés à l'entrée de celui-ci.

Dans l'article de G.D. TATTERSALL et M.J. CAREY intitulé « Digital Bandlimiting Filters for PCM Transmission Systems » publié dans la revue « IEEE Transactions on Communications », vol. COM 27, n° 1, janvier 1979, pp. 240-246, il est proposé de réaliser de tels filtres récursifs en utilisant une technique communément appelée « arithmétique distribuée ».

La présente invention reprend cette idée du filtre récursif en arithmétique distribuée, mais apporte un perfectionnement en ce sens que, par une adaptation judicieuse des circuits inhérents à l'arithmétique distribuée et des circuits permettant le suréchantillonnage, il est possible de faire une économie de moyens non négligeable (sur le nombre de registres d'entrée notamment) tout en gardant une grande souplesse d'emploi.

Le filtrage numérique récursif est classiquement caractérisé par une expression de la forme :

$$y_n = \sum_{k=0}^{p} a_k \, x_{n-k} - \sum_{k=1}^{q} b_k \, y_{n-k} \tag{1}$$

où $x_{n-k}$ désigne des signaux d'entrée de rang $n - k$, $Y_{n-k}$ des signaux de sortie de rang $n - k$ réinjectés à l'entrée du filtre, $a_k$ des coefficients de la partie non récursive, dont l'ordre est p et $b_k$ des coefficients de la partie récursive, dont l'ordre est q ; l'indice n prend des valeurs entières et caractérise le signal de sortie.

L'expression (1) est un cas particulier d'une expression plus générale exprimant une somme pondérée pouvant s'exprimer par :

$$v = \sum_{k=1}^{p} a_k \, u_k \tag{2}$$

Un filtre numérique récursif comprend p + 1 entrées recevant les signaux $x_k$ et q entrées recevant les signaux $y_k$, soit au total p + q + 1 entrées ; il comprend également une sortie délivrant la suite des signaux $y_n$.

La fonction de transfert H(z) d'un tel filtre, exprimée à l'aide de la variable complexe z, est :

$$H(z) = \frac{\displaystyle\sum_{k=0}^{p} a_k \, z^{-k}}{1 + \displaystyle\sum_{k=1}^{q} b_k \, z^{-k}} \tag{3}$$

2

L'invention s'inscrit dans le cadre d'une technique particulière de traitement numérique dénommée « arithmétique distribuée ». Cette technique est décrite dans le brevet américain n° 3 777 130 délivré le 4 décembre 1973 à A. CROISIER, D.J. ESTEBAN, M.E. LEVILION et V. RISO et intitulé « Digital Filter for PCM Encoded Signals » ainsi que dans l'article de A. PELED et B. LIU intitulé « A new Hardware Realization of Digital Filters » publié dans la revue « IEEE Trans. on ASSP » vol. ASSP 22, pp 456-462 en décembre 1974. En outre, l'article de C.S. BURRUS intitulé « Digital Filter Structures Described by Distributed Arithmetic » publié dans la revue « IEEE Trans on Circuits and Systems », vol. CAS-24, N° 12, décembre 1977, pp 674-680, fournit une approche générale de cette question et décrit divers algorithmes et architectures utilisables. On pourra se reporter à ces documents pour tout détail concernant cette technique de l'arithmétique distribuée, celle-ci n'étant que brièvement rappelée ci-dessous afin que la compréhension de l'invention en soit facilitée.

Il s'agit d'effectuer une somme pondérée de signaux exprimée par la relation (2). On suppose que les $u_k$ sont codés sur r bits en code complément à 2 mais d'autres codes sont naturellement possibles. On note $u_k(0)$ le bit de signe et $u_k(j)$ les bits représentatifs de la valeur absolue de $u_k$, l'indice j étant compris entre 0 (exclus) et $r - 1$ (inclus). On peut donc écrire :

$$u_k = - u_k(0) \ 2^0 + \sum_{j=1}^{r-1} u_k(j) \ 2^{-j} \qquad (4)$$

si $-1 < u_k < 1$

Alors, après interversion des sommations, on peut écrire v sous la forme :

$$v = - 2^0 \left( \sum_{k=1}^{p} u_k(0) \ a_k \right) + \sum_{j=1}^{r-1} 2^{-j} \left( \sum_{k=1}^{p} u_k(j) \ a_k \right) \qquad (5)$$

Dans cette relation, le terme $u_k(j)$ qui figure dans l'expression entre parenthèses est le bit de rang j de $u_k$ et ce bit ne peut prendre que deux valeurs : 0 ou 1. Pour le premier produit $u_1(j)a_1$ il n'y a donc que deux valeurs possibles : 0 ou $a_1$. De même pour le produit $u_2(j)a_2$ qui ne peut prendre que les deux valeurs 0 et $a_2$ ; il n'y a donc que 4 valeurs possibles pour la somme de ces deux produits, à savoir 0, $a_1$, $a_2$, ou $a_1 + a_2$. De proche en proche, on voit qu'il y a finalement $2^p$ valeurs possibles pour la somme :

$$\sum_{k=1}^{p} u_k(j) \ a_k \ .$$

Cette somme, qui sera notée $w_j$ (puisqu'elle dépend du rang j considéré) prend donc l'une quelconque de $2^p$ valeurs déterminées uniquement par les coefficients $a_k$. Le calcul de la somme pondérée revient donc au calcul de l'expression :

$$v = - 2^0 \cdot w_0 + \sum_{j=1}^{r-1} w_j \ 2^{-j}$$

où les $w_j$ peuvent être prédéterminés dès que l'on s'est fixé un jeu de coefficients $a_k$.

Celle de ces $2^p$ valeurs qui doit être retenue pour former $w_j$ est définie par l'ensemble des p bits de rang j des signaux d'entrée, à savoir $u_1(j)$, $u_2(j)$ ... $u_p(j)$.

Dans un circuit de traitement à arithmétique distribuée les quantités $w_j$ sont inscrites dans une mémoire de $2^p$ mots de m bits, si m est le nombre de bits nécessaire pour exprimer ces sommes partielles. Le mot correspondant à un $w_j$ particulier est situé, dans cette mémoire, à l'adresse correspondant aux p bits de rang j des signaux d'entrée $u_k$.

Le nombre m est déterminé à partir des contraintes du problème à traiter et il peut être réduit de deux manières différentes : par troncation des coefficients $a_k$ comme dans une réalisation conventionnelle, ou par troncation directe des quantités $w_j$ (mais alors le traitement n'est plus rigoureusement linéaire). Cette dernière méthode est décrite dans l'article de R. LAGADEC et D. PELLONI intitulé « A Model for Distributed Arithmetic for Filters with Post-Quantized Look-up Table » publié dans « National Telecommunication Conference » 1977, pp 29 : 3-1 à 29 : 3-6.

Si les signaux d'entrée $u_k$ sont introduits dans des registres série, poids faible en tête, et si l'on dispose en sortie de la mémoire contenant les $w_j$ précalculés d'une unité arithmétique composée d'un additionneur-soustracteur, d'un registre accumulateur à entrées parallèles et sorties parallèles pouvant être décalé, on peut réaliser la somme pondérée v en r opérations élémentaires telles que :

— lecture de la mémoire à l'adresse donnée par les p bits $u_k(j)$,

— addition du contenu du registre accumulateur parallèle-parallèle et du mot contenu dans la mémoire à l'adresse indiquée (pour j = 0, il faut soustraire le contenu de la mémoire au contenu du registre),

— décalage du registre accumulateur parallèle-parallèle et des registres série d'entrée (qui correspond à une division par deux du résultat intermédiaire).

**0 047 199**

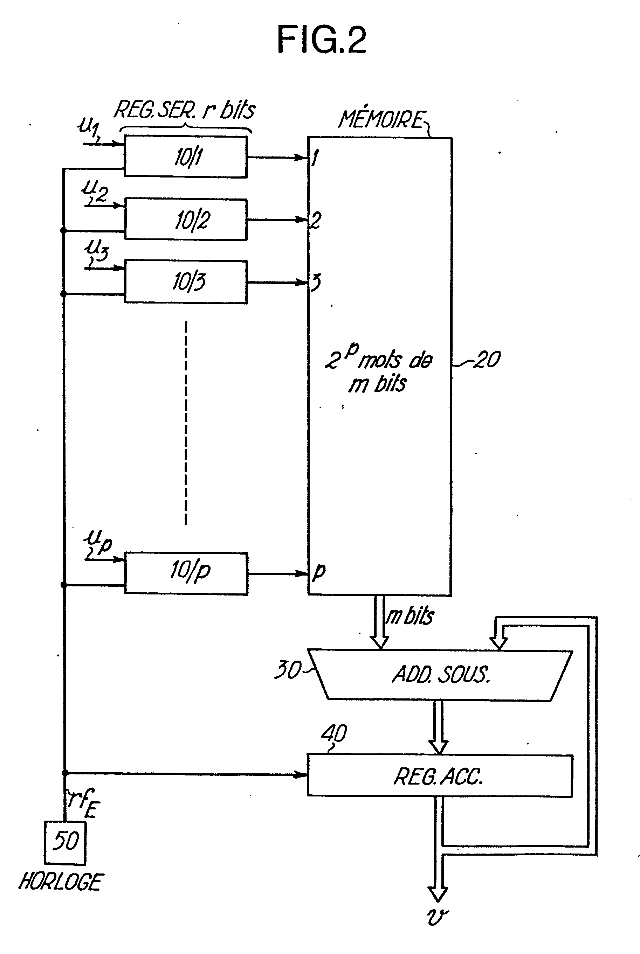

L'organisation matérielle d'un tel circuit est illustrée sur la figure 2. Le circuit représenté comprend : p registres-série 10/1, 10/2, ..., 10/p de r bits recevant les p signaux d'entrée 20, une mémoire morte de $2^p$ mots de m bits, un additionneur-soustracteur 30, un registre à entrées parallèles et sorties parallèles 40 décalable et un circuit d'horloge 50.

La mémoire possède p entrées reliées aux sorties des p registres d'entrée et elle contient les $2^p$ quantités suivantes :

$$\sum_{k=1}^{p} a_k \, \varepsilon_k$$

où $\varepsilon_k$ prend les valeurs 0 ou 1 ; l'adresse de chaque quantité est constituée par p bits appliqués aux p entrées.

Avec de tels moyens on réalise en r coups d'horloge l'équivalent de p multiplications et $(p - 1)$ additions, le déroulement des opérations étant le suivant :

Les quantités $u_k$ se présentent poids faible en tête dans les registres 10/1, ..., 10/p. La première quantité calculée est :

$$w_{r-1} = \sum_{k=1}^{p} u_k(r - 1) \, a_k$$

puis, après décalage du registre 40, on calcule : $2^{-1}w_{r-1}$, $w_{r-2}$, puis la somme $w_{r-2} + 2^{-1} \, w_{r-1}$, puis, après un nouveau décalage, on calcule :

$$2^{-1}(w_{r-2} + 2^{-1} \, w_{r-1}) = 2^{-1} \, w_{r-2} + 2^{-2} \, w_{r-1}$$

et ainsi de suite jusqu'au $r^{\text{ième}}$ coup d'horloge, où l'on doit effectuer une soustraction correspondant aux bits de signe $u_k(0)$. Après ce dernier coup, les registres série 10/1, ..., 10/p doivent être décalés. On peut également tronquer ou arrondir le résultat v. Pour faire de la troncation, il suffit de ne pas prendre en compte les bits de faible poids, à partir d'un certain moment. Pour faire de l'arrondi, il faut ajouter, avant troncation des résultats, un demi-poids faible.

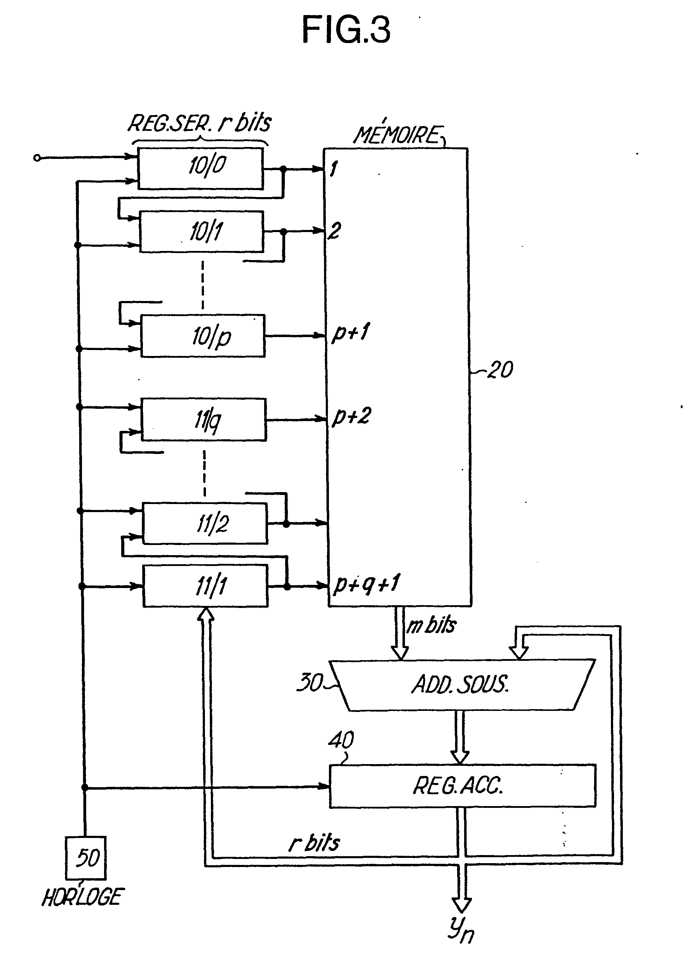

Ces principes peuvent être appliqués à la réalisation d'un filtre numérique récursif. L'opération à effectuer est alors celle de la relation (1) et le circuit correspondant est celui de la figure 3. Il comprend une partie non récursive constituée de $p + 1$ registres série 10/0, 10/1, ..., 10/p recevant les signaux $x_n$, $x_{n-1}$, ..., $x_{n-p}$ et une partie récursive constituée de q registres 11/1, 11/2, ..., 11/q recevant les signaux $y_{n-1}$, $y_{n-2}$, ..., $y_{n-q}$, le registre 11/1 étant à chargement parallèle et les autres à chargement série ; les registres 10/0 à 10/p − 1 ont leur sortie reliée à l'entrée du registre suivant, de même que les registres 11/1 à 11/q − 1. Le circuit comprend encore une mémoire 20 à $p + q + 1$ entrées reliées à la sortie des registres, cette mémoire contenant $2^{p+q+1}$ mots de m bits, ces mots étant les quantités :

$$\sum_{j=0}^{p} a_j \, \varepsilon_{j+1} - \sum_{k=1}^{q} b_k \, \varepsilon_{p+q+2-k}$$

où les $\varepsilon j$ sont égaux à 0 ou 1, j allant de 1 à $p + q + 1$.

Le circuit comprend enfin les organes de traitement arithmétique déjà mentionnés, à savoir : un additionneur-soustracteur 30, un registre-accumulateur 40 à entrées parallèles et sorties parallèles, ainsi qu'une horloge 50 assurant le déroulement convenable des opérations (décalage des registres, chargement des registres parallèles, remise à zéro de l'accumulateur en fin de cycle).

Par rapport au circuit de la figure 2, on note donc deux modifications :

— le registre 11/1 correspondant à $y_{n-1}$ est à chargement parallèle ; le contenu du registre parallèle-parallèle 40 doit être limité à r bits (par troncation ou arrondi), puis, à la fin de chaque cycle de calculs (r opérations élémentaires) chargé dans le registre $y_{n-1}$ de manière parallèle,

— les différents registres série sont connectés les uns aux autres.

L'invention est basée sur un certain nombre de propriétés présentées par les filtres récursifs lorsqu'on utilise l'arithmétique distribuée, propriétés qui ont été mises en évidence par les demandeurs et qui peuvent être résumées comme suit.

Dans un filtre récursif de suréchantillonnage, les signaux de sortie $y_n$ sont échantillonnés à une fréquence N fois plus grande que les signaux d'entrée $x_n$. Le calcul de l'expression :

$$y_n = \sum_{k=0}^{p} a_k \, x_{n-k} - \sum_{k=1}^{q} b_k \, y_{n-k} \tag{1}$$

présente donc des particularités puisque les échantillons $x_{n-k}$ seront nuls $(N - 1)$ fois sur N alors que les échantillons $y_{n-k}$ seront toujours présents. Pour préciser ce point, on notera l'indice courant n sous la

4

forme n = tN + j qui fait apparaître la multiplicité par rapport à N et où l'indice j prend toutes les valeurs comprises entre 0 (inclus) et N − 1 (inclus).

Lorsque j = 0, l'indice n est un multiple de N ; lorsque k prend toutes les valeurs comprises entre 0 et p la première sommation fait intervenir les coefficients $a_0$, $a_1$, $a_2$,...,$a_p$ et les échantillons $x_{tN}$, $x_{tN-1}$, $x_{tN-2}$, ... Or, parmi ces échantillons, seuls les échantillons dont le rang est un multiple entier de N ne sont pas nuls : il s'agit de $x_{tN}$, $x_{tN-N}$, $x_{tN-2N}$, ... La première sommation ne fera donc intervenir que certains des produits. Par exemple pour N = 4, la sommation ne contiendra que les termes $a_0 x_{t4}$, $a_4 x_{t4-4}$,.... Autrement dit tout se passe comme si l'on avait affaire à un filtre ordinaire avec le jeu de coefficients $a_0$, $a_4$,... (l'indice ne pouvant naturellement excéder l'ordre p de la partie non récursive).

Pour le rang n qui suit, on a j = 1 et les échantillons intervenant dans la première sommation sont, cette fois, $x_{tN+1}$, $x_{tN}$, $x_{tN-1}$, etc... ; cette fois, c'est le second échantillon $x_{tN}$, le cinquième, etc... qui sont non nuls ; les produits à prendre en compte seront donc cette fois (et toujours dans le cas où N = 4) $a_1 x_{t4}$, $a_5 x_{t4-N}$,.... Le jeu de coefficients qui intervient est donc $a_1$, $a_5$,...

Pour l'indice n suivant, obtenu pour j = 2, on trouve de la même manière que le jeu de coefficients qui intervient est $a_2$, $a_6$,...

Enfin, pour l'indice n obtenu avec j = 3, le jeu de coefficients est $a_3$, $a_7$,...

Pour la valeur suivante de n on retrouve j = 0 avec t augmenté d'une unité et l'on retrouve les 4 jeux précédents de coefficients ($a_0$, $a_4$), ($a_1$, $a_5$),...

Le tableau I donné ci-après rassemble les différents échantillons d'entrée $x_{n-k}$ (les échantillons non nuls étant soulignés) dans le cas où le facteur de suréchantillonnage N est égal à 4 pour les 4 valeurs de j. On observera que cet exemple correspond au cas illustré sur la figure 1 où les fréquences d'échantillonnage sont égales respectivement à 32 kHz et 8 kHz à la sortie et à l'entrée. Dans ce tableau, l'ordre p de la partie non récursive est égal à 6 (ce qui conduit à une sommation sur 7 termes allant de k = 0 à k = 6). Les jeux de coefficients à prendre en compte pour chaque valeur de j (donc de n) sont indiqués en bas de chaque colonne. Il y a 4 jeux différents et d'une façon générale N.

Par ailleurs, dans l'exemple pris, il y a au maximum deux échantillons non nuls intervenant dans une sommation sur k pour n fixé. Naturellement, ce nombre dépend de l'ordre p : plus l'ordre p est grand, plus le nombre d'échantillons pouvant ne pas être nuls augmente. Dans l'exemple du tableau I, on aurait pu prendre p = 7, sans augmenter le nombre d'échantillons non nuls intervenant dans la sommation.

L'ordre p est toujours compris entre deux multiples successifs de N, notés (K − 1) N et KN avec égalité possible pour le premier. Dans le cas particulier correspondant à p = 6 et N = 4, on a ainsi K = 2 (6 est bien compris entre 1 × 4 et 2 × 4). Il est aisé de voir que le nombre d'échantillons à prendre en compte dans la sommation sur k de la partie non récursive est d'une façon générale, au plus égal à K.

Ainsi, et selon l'une des caractéristiques du filtre de l'invention, le nombre de registres série recevant les signaux d'entrée et constituant la partie non récursive d'ordre p est limité à K, K étant défini (dans le cas où N = $2^\alpha$) par :

$$(K - 1) \, N \leqslant p < KN \qquad\qquad (4)$$

On observera que dans l'art antérieur, le nombre de registres utilisés était égal à p + 1, comme illustré sur la figure 3.

Selon une autre caractéristique du filtre de l'invention, les N jeux différents de coefficients qui sont à utiliser tour à tour lorsque le rang n varie, (dans l'exemple du tableau I : ($a_0$, $a_4$), ($a_1$, $a_5$), ($a_2$, $a_6$), ($a_3$), sont stockés dans N (ici 4) blocs de la mémoire, ces blocs ayant même taille, et étant adressés à tour de rôle selon la valeur de n. Cet adressage est obtenu par un compteur modulo N qui reçoit les impulsions de commande à la fréquence $f_S$ et dont les sorties sont reliées à des entrées d'adressage de la mémoire. Lorsque N est compris entre $2^{\alpha-1}$ (exclus) et $2^\alpha$ (inclus), le compteur en question comprend $\alpha$ sorties et la mémoire $\alpha$ entrées d'adressage des N blocs-mémoire. Par ailleurs, cette mémoire doit comprendre K entrées correspondant aux K registres-série de la partie non récursive et également q entrées correspondant aux q registres de la partie récursive ordinaire. La mémoire possède donc en définitive $\alpha + K + q$ entrées d'adressage et une capacité de $2^{\alpha+K+q}$ mots de m bits.

Cette seconde caractéristique permet de souligner la seconde économie de moyens réalisée par l'invention. Dans l'art antérieur, la mémoire associée à une partie récursive d'ordre q et à une partie non récursive d'ordre p doit posséder une capacité de $2^{p+q+1}$ mots. Le gain procuré par l'invention, en ce qui concerne la taille de la mémoire est donc, dans le cas général de :

$$2^{p+q+1}/2^{\alpha+K+q}$$

Dans le cas le plus favorable où p = K(N − 1) et N = $2^\alpha$, ce gain est de $2^{K(N-1)}/N$, quantité qui est supérieure à 1 dès que N ⩾ 2 et K > 1.

Dans le cas le plus défavorable correspondant à p = (K − 1) N et N = $2^{\alpha-1} - 1$, le gain est de $2^{K(N-1)-N}/N - 1$, quantité qui est supérieure à 1 dès que N ⩾ 2 et K ⩾ 2.

Dans le cas où N n'est pas une puissance de 2, l'expression (4) prend une forme différente :

$$(K - 1) \, N + 2^\alpha - N \leqslant p < KN + 2^\alpha - N \qquad\qquad (5)$$

5

**0 047 199**

et lorsque les signaux sont répétés P fois sur N à l'entrée, la forme la plus générale suivante :

$$(K - 1) N + 2^\alpha - N \leqslant p + P - 1 < KN + 2^\alpha - N \qquad \cdot \qquad (6)$$

De façon précise, l'objet de l'invention peut donc être défini de la manière suivante. Il s'agit d'un filtre numérique récursif de suréchantillonnage en arithmétique distribuée, comprenant une partie récursive d'ordre q constituée d'un registre à chargement parallèle et de q − 1 registres-série, ces q registres étant circulants, c'est-à-dire reliés en cascade, une partie non récursive d'ordre p constituée de registres-série, une mémoire divisée en N blocs-mémoire contenant chacun un jeu de quantités précalculées caractéristiques du filtrage à effectuer, un compteur modulo N à $\alpha$ sorties, la mémoire possédant d'une part $\alpha$ entrées d'adressage des différents blocs reliées aux $\alpha$ sorties du compteur et, d'autre part, des entrées d'adressage à l'intérieur d'un bloc reliées aux sorties des registres des parties récursive et non récursive, un additionneur-soustracteur relié à la mémoire, un registre-accumulateur dont l'entrée est reliée à l'additionneur soustracteur et à la sortie au registre à chargement parallèle, et à l'additionneur-soustracteur, les signaux d'entrée de la partie non récursive pouvant être bloqués P fois sur N une horloge de fréquence $f_S$ commandant la sortie des signaux du registre accumulateur et leurs entrées dans la partie récursive et actionnant le compteur, la fréquence de décalage des registres étant $rf_S$ si r est la longueur commune aux différents registres série, la fréquence $f_S$ étant égale à $Nf_E$ où N est un entier, $f_E$ la fréquence d'échantillonnage des signaux à l'entrée du filtre, et $f_S$ la fréquence en sortie du filtre ; ce filtre est caractérisé en ce que la partie non récursive ne comprend que K registres-série, K étant un entier défini par la double inégalité :

$$(K - 1) N + 2^\alpha - N \leqslant p + P - 1 < KN + 2^\alpha - N$$

et en ce qu'il comprend des moyens de commutation aptes à rendre ces K registres recirculants, c'est-à-dire bouclés sur eux-mêmes, N − 1 fois sur N, et circulants, c'est-à-dire reliés en cascade les uns aux autres, une fois sur N, ces moyens de commutation étant commandés par les sorties du compteur.

De préférence, les moyens de commutation sont constitués par K multiplexeurs à deux entrées de signal et une sortie et une entrée de commande reliée au compteur.

De préférence encore, des multiplexeurs peuvent être insérés entre la mémoire et les registres afin de diminuer la taille de la mémoire.

De préférence encore, lorsque N n'est pas une puissance de 2, c'est-à-dire lorsque N diffère de $2^\alpha$, l'invention prévoit un multiplexage de certains registres d'entrée avec des sorties du compteur, ce qui permet d'optimiser l'utilisation de la mémoire.

De toute façon, les caractéristiques et avantages de l'invention apparaîtront mieux après la description qui va suivre, d'exemples de réalisation donnés à titre illustratif et nullement limitatif. Cette description se réfère à des dessins annexés, qui font suite aux figures déjà décrites et sur lesquels :

la figure 4  représente un exemple de réalisation d'un filtre récursif de suréchantillonnage conforme à l'invention, dans le cas particulier où la partie non récursive comprend deux registres-série (K = 2) et la partie récursive 6 registres-série ;

la figure 5  représente une variante de réalisation du filtre précédent utilisant des multiplexeurs à deux entrées disposés entre les registres et la mémoire ;

la figure 6  représente une autre variante du filtre précédent utilisant des multiplexeurs à 4 entrées ;

la figure 7  représente une variante permettant d'optimiser le remplissage de la mémoire lorsque le facteur de suréchantillonnage n'est pas une puissance de 2 ;

la figure 8  représente encore une autre variante de réalisation du filtre précédent correspondant au cas où le facteur de suréchantillonnage N est différent d'une puissance de 2 et où il est fait usage d'un registre supplémentaire multiplexé avec une des sorties du compteur.

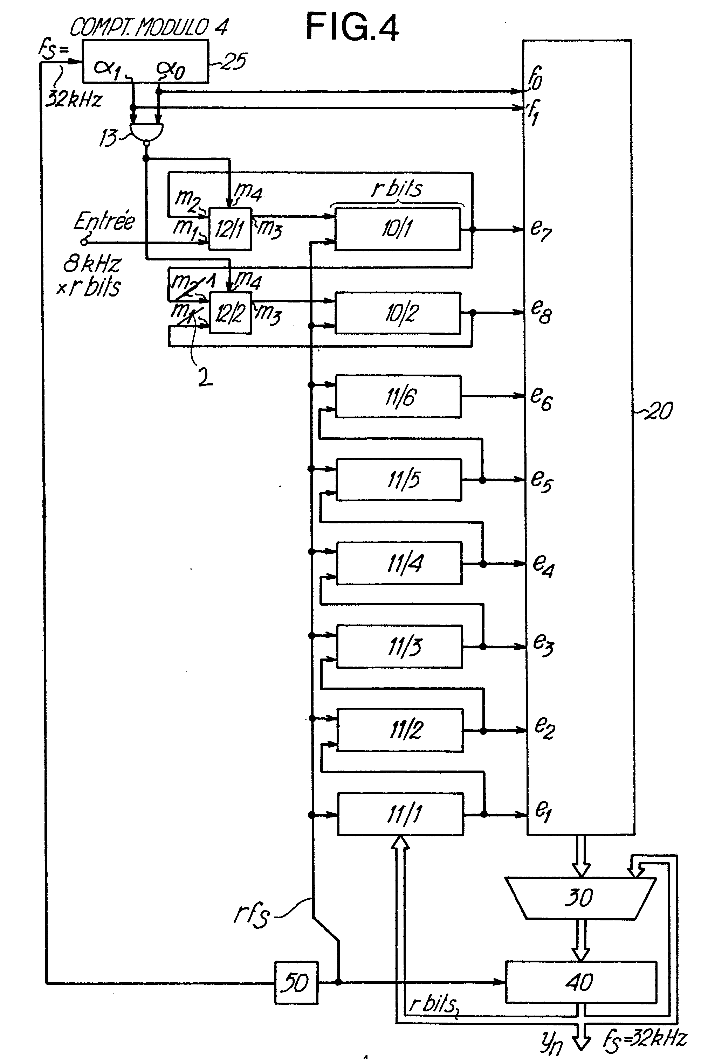

La figure 4 représente un exemple de filtre conforme à l'invention et correspondant au cas où l'ordre q de la partie récursive est égal à 6, où l'ordre p de la partie non récursive est égal à 7, où N = 4, conditions qui conduisent à K = 2 et $\alpha$ = 2.

Le filtre représenté comprend une partie récursive constituée d'un registre à chargement parallèle 11/1 et de 5 registres-série 11/2, 11/3...11/6, ces registres étant tous circulants, c'est-à-dire reliés en cascade, les uns aux autres, et une partie non récursive constituée de deux registres-série 10/1 et 10/2 associés chacun à un multiplexeur à deux entrées 12/1 et 12/2. Le filtre comprend encore une mémoire 20 divisée en 4 blocs-mémoire de mêmes tailles contenant chacun un jeu de quantités précalculées caractéristiques du filtrage à effectuer et un compteur 25 modulo 4 à 2 sorties $\alpha_0$ et $\alpha_1$ ; la mémoire 20 possède d'une part 2 entrées $f_0$, $f_1$ d'adressage des 4 blocs, ces entrées étant reliées aux 2 sorties du compteur et, d'autre part, 8 entrées $e_1$, $e_2$ ... $e_8$ d'adressage d'un mot à l'intérieur d'un bloc, ces entrées étant reliées aux sorties de 8 registres des parties récursive et non récursive ; le filtre comprend encore et de manière connue, un ensemble additionneur-soustracteur 30 et un registre-accumulateur 40 dont la sortie est reliée au registre 11/1 à chargement parallèle ; enfin, une horloge 50 actionne les registres des parties non récursive et récursive à la fréquence $rf_S$ où r est le nombre de bits des signaux traités, et le compteur 25 et le chargement parallèle du registre 11/1 à la fréquence $f_S$.

Les moyens de commutation aptes à rendre les 2 registres 10/1 et 10/2 recirculants, c'est-à-dire

6

bouclés sur eux-mêmes, 3 fois sur 4 et circulants, c'est-à-dire reliés en cascade les uns aux autres, une fois sur 4, sont constitués par les deux multiplexeurs 12/1 et 12/2 et par une porte NON-ET 13 à deux entrées reliées aux sorties $\alpha_0$ et $\alpha_1$ du compteur 25. Chaque multiplexeur possède deux entrées de signal $m_1$ et $m_2$, une sortie $m_3$ et une entrée de commande $m_4$ ; la seconde entrée $m_2$ de chaque multiplexeur est reliée à la sortie du registre-série auquel il est associé, la première entrée $m_1$ étant reliée à la sortie du registre qui précède, sauf pour le premier 12/1 dont l'entrée est reliée à une entrée générale des signaux à traiter ; l'entrée de commande des multiplexeurs est reliée à la sortie de la porte NON-ET. Elle est donc à l'état 0 uniquement lorsque les deux sorties $\alpha_0$ et $\alpha_1$ sont à 1, autrement dit lorsque le contenu du compteur est à son maximum (N − 1 si l'on compte de 0 à N − 1, N si l'on compte de 1 à N) ; alors la sortie $m_3$ de chaque multiplexeur est reliée à la première entrée $m_1$, ce qui rend les deux registres 10/1 et 10/2 circulants. Dans les trois autres cas, la sortie de la porte NON-ET est à 1 et la sortie $m_3$ est reliée à la seconde entrée $m_2$, ce qui rend les deux registres recirculants.

Dans l'exemple illustré, la capacité de la mémoire est de $2^{2+2+6} = 2^{10}$, soit 1 024 mots au lieu de $2^{6+6+1} = 2^{13}$, soit 8 192 mots, comme dans l'art antérieur, soit un gain de 8 sur la taille de la mémoire.

Les dispositions qui viennent d'être décrites peuvent être facilement modifiées si les signaux d'entrée sont répétés (ou bloqués) à l'entrée du filtre, selon un processus connu. Si l'on répète P fois sur N les signaux à l'entrée d'un filtre, le signal subit un filtrage complémentaire de fonction de transfert ;

$$G_p(f) = |(\sin \pi\, Pf/f_S)/(\sin \pi\, f/f_S)| \qquad (7)$$

qu'il faut corriger en bande passante, mais dont l'affaiblissement hors bande (en particulier les zéros à $f = kf_S/P$) peut faciliter la synthèse d'un filtre satisfaisant à un gabarit donné.

Le cas considéré jusqu'ici correspond à P = 1 et il n'y a pas alors de fonction de transfert parasite $(G_1(f) = 1)$.

Lorsqu'on répète les échantillons d'entrée P fois sur N, pour retrouver la puissance du signal d'entrée en sortie, il faut multiplier les échantillons d'entrée par N/P (ou multiplier les coefficients de la partie non récursive par N/P). Lorsque P = N, (cas connu sous le nom de « bloqueur d'ordre zéro »), ce facteur multiplicatif est égal à 1 et la fonction de transfert est :

$$G_N(f) = |(\sin \pi\, Nf/f_s)/(\sin \pi\, f/f_s)| . \qquad (8).$$

Si les signaux d'entrée sont bloqués, le nombre de $x_{n-k}$ à prendre en considération dans la sommation sur k augmente et, par conséquent, le nombre de coefficients $a_k$ intervenant dans chaque jeu. Le tableau II donné ci-après reprend le cas envisagé au tableau I dans le cas où les signaux sont bloqués 2 fois sur 4. On voit que lorsque j = 0 (première colonne) l'échantillon de rang k = 3 n'est plus nul puisqu'il correspond à $x_{tN-4}$ répété ; ainsi, les coefficients intervenant dans la sommation pour j = 0 ne sont-ils plus $a_0$ et $a_4$, mais $a_0$ et $(a_3 + a_4)$. De même pour j = 1 où l'on doit retenir le jeu des coefficients $(a_0 + a_1)$, $(a_4 + a_5)$, etc...

D'une façon générale, on peut montrer que les N jeux de coefficients à prendre en compte, lorsqu'on répète P fois sur N les signaux d'entrée, sont les suivants :

pour j = 0 :
$$a_0, \quad \sum_{k=N+1-P}^{N} a_k, \quad \sum_{k=2N+1-P}^{2N} a_k \dots$$

pour j = 1 :
$$a_0 + a_1, \quad \sum_{k=N+2-P}^{N+1} a_k, \quad \sum_{k=2N+2-P}^{2N+1} a_k \dots$$

pour j = P :
$$\sum_{k=1}^{P} a_k, \quad \sum_{k=N+1}^{N+P} a_k, \quad \sum_{k=2N+1}^{2N+P} a_k \dots$$

pour j = N − 1 :
$$\sum_{k=N-P}^{N-1} a_k, \quad \sum_{k=2N-P}^{2N-1} a_k, \quad \sum_{k=3N-P}^{3N-1} a_k \dots$$

En faisant P = 1, on retrouve les résultats du tableau I et en faisant P = 2 ceux du tableau II.

Cette modification touche donc les quantités précalculées à introduire dans la mémoire 20. En outre, le nombre K de registres à utiliser à l'entrée est défini par la double inégalité :

$$(K - 1)\, N \leqslant p + P - 1 < KN \qquad (9)$$

Les dispositions qui précèdent permettent de réduire la taille de la mémoire. Cette taille peut encore être réduite si l'on dispose des multiplexeurs entre la mémoire et les registres au prix d'une multiplication de la fréquence de calcul par M, si M est le facteur de multiplexage. Naturellement des précautions doivent être prises pour que, lorsqu'une entrée $x_{n-k}$ est adressée sur la mémoire, la partie de la mémoire contenant le jeu de coefficients devant être utilisé soit correctement adressée, ce qui suppose que les $\alpha$

entrées de la mémoire correspondant à l'adressage des blocs reçoivent les bits délivrés par le compteur modulo N.

Deux solutions peuvent être envisagées :

— soit ne faire porter le multiplexage que sur les (K + q) entrées de la mémoire raccordées à des registres,

— soit répéter si nécessaire les $\alpha$ bits obtenus en sortie du compteur de façon que pour chaque $x_{n-k}$ sélectionné par un multiplexeur, les $\alpha$ bits du compteur soient également sélectionnés.

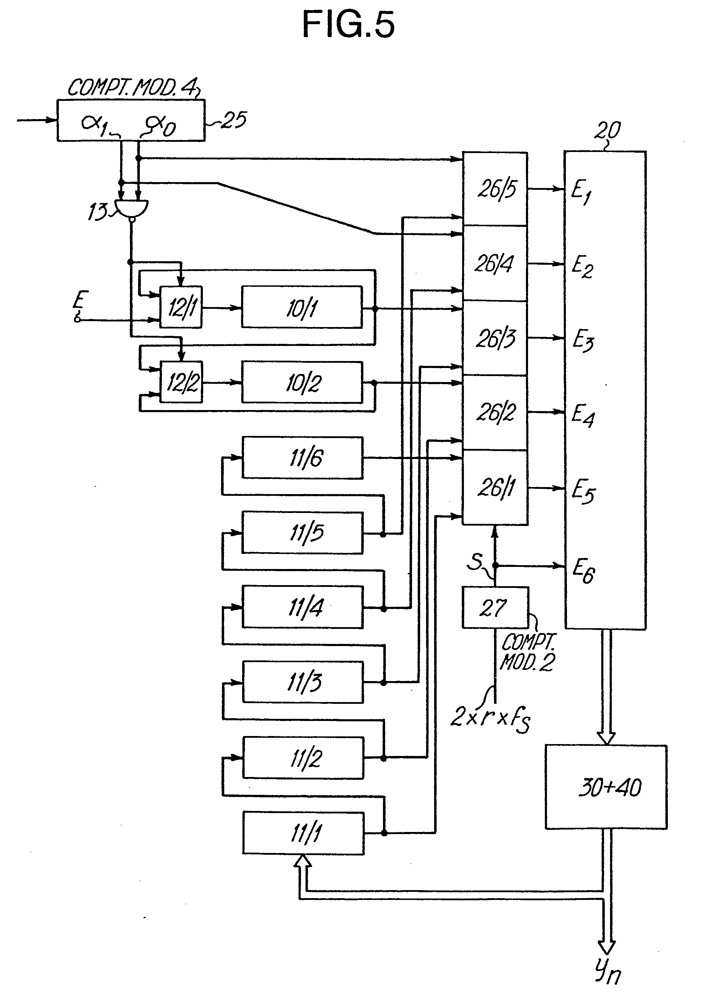

La figure 5 illustre le cas où 5 multiplexeurs 26/1 à 26/5 à M = 2 entrées et une sortie sont disposés entre la mémoire 20 d'une part, les registres et le compteur 25 d'autre part, dans un exemple qui correspond au cas illustré sur la figure 4. Ces multiplexeurs sont commandés par un compteur 27 modulo 2 qui travaille à la fréquence 2 $rf_s$ et qui délivre un bit S égal à 0 ou 1. La mémoire 20 présente alors 6 entrées respectivement $E_1$ à $E_6$. Lorsque S est à 1 ces entrées sont respectivement reliées à $\alpha_0$, $\alpha_1$, 10/1, 10/2, 11/6 et 27 ; lorsque S est à 1 elles sont reliées à 11/5, 11/4, 11/3, 11/2, 11/1 et 27. La mémoire ne présente donc qu'une taille de $2^6 = 64$ mots de m bits, soit une réduction d'un facteur 16 par rapport au cas de la figure 4.

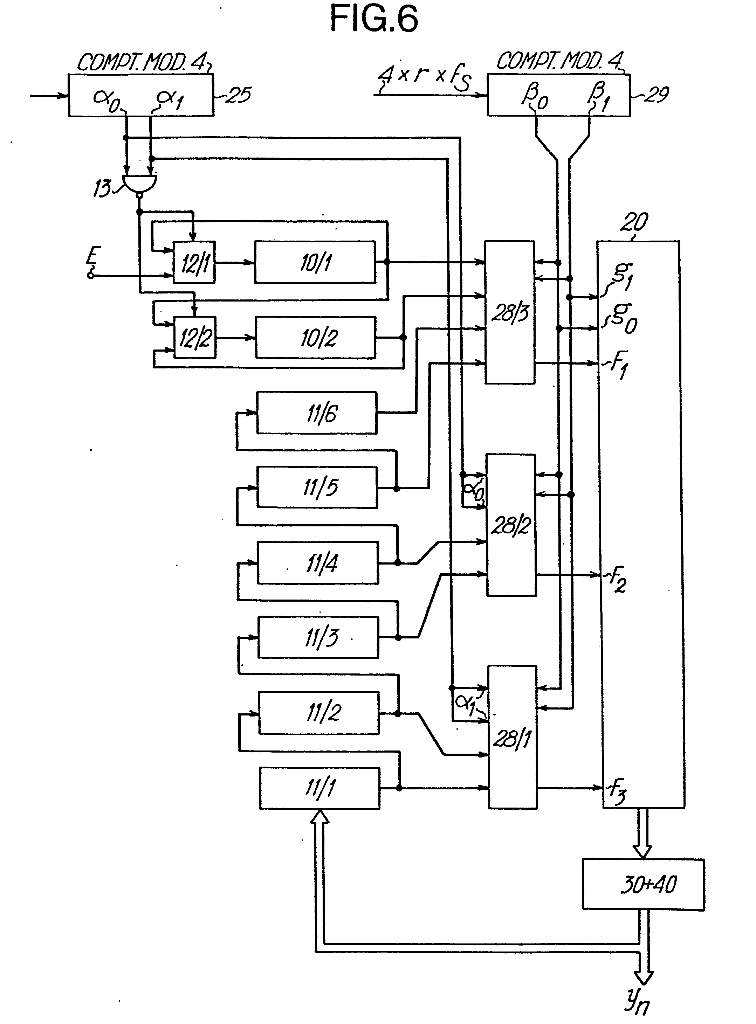

La figure 6 représente un autre exemple d'utilisation de multiplexeurs, cette fois à M = 4 entrées. Trois multiplexeurs 28/1, 28/2 et 28/3 sont commandés par un compteur 29 modulo 4 à deux sorties $\beta_0$ et $\beta_1$. La mémoire comprend deux entrées $g_0$ et $g_1$ reliées aux sorties du compteur 29 modulo 4 et 3 entrées $F_1$, $F_2$, $F_3$. La correspondance entre les bits délivrés par le compteur 29 et les éléments auxquels les trois entrées $F_1$ à $F_3$ sont reliées est la suivante :

| $\beta_0$ | $\beta_1$ | Entrée $F_1$ reliée à | Entrée $F_2$ reliée à | Entrée $F_3$ reliée à |
|---|---|---|---|---|
| 0 | 0 | 10/1 | $\alpha_0$ | $\alpha_1$ |
| 0 | 1 | 10/2 | $\alpha_0$ | $\alpha_1$ |
| 1 | 0 | 11/6 | 11/4 | 11/2 |
| 1 | 1 | 11/5 | 11/3 | 11/1 |

La mémoire ne présente alors qu'une taille de $2^5 = 32$ mots de m bits.

Dans la description qui précède, le facteur de suréchantillonnage N est supposé être une puissance de 2 ($N = 2^\alpha$). Dans le cas où cette condition n'est pas satisfaite, l'invention prévoit une disposition particulière qui permet d'optimiser le remplissage de la mémoire.

Cette variante de l'invention est basée sur les remarques suivantes : le contenu du compteur varie entre 0 et N − 1 (un raisonnement analogue pourrait être tenu si ce contenu variait entre 1 et N). Les configurations binaires délivrées par les $\alpha$ sorties du compteur et correspondant à N, N + 1, ..., $2^\alpha - 1$ ne sont donc jamais atteintes. Cela signifie que certaines configurations comprises entre 0 et N − 1 seront entièrement caractérisées par un nombre de bits inférieur strictement à $\alpha$. Autrement dit, parmi les $\alpha$ bits délivrés par le compteur, il en est qui peuvent ne pas être significatifs, c'est-à-dire n'avoir aucune incidence sur la commande de l'adressage de la mémoire.

Par exemple, pour N = 3, le compteur 25 compte de 0 à 2. Les configurations binaires délivrées par ses sorties sont donc les suivantes :

| $\alpha_1$ | $\alpha_0$ |
|---|---|
| 0 | 0 |
| 0 | 1 |
| 1 | 0 |

La configuration binaire 11 n'est jamais produite puisque le contenu du compteur n'atteint pas 3. Il en résulte que si $\alpha_1$ est à 1, le bit de poids faible $\alpha_0$ n'est pas significatif puisqu'à lui seul $\alpha_1 = 1$ suffit pour adresser un des blocs de la mémoire, le bit $\alpha_0$ n'intervenant pas dans cet adressage. On peut donc libérer une entrée de la mémoire lorsque $\alpha_1 = 1$ et affecter cette entrée à une donnée, ce qui permet de constituer un bloc mémoire de taille double. Cette commutation peut être obtenue par un multiplexeur.

D'une façon générale, on peut montrer qu'une mémoire de $2^{\alpha+n}$ mots peut être partitionnée en blocs-mémoire de $2^n$ mots et en blocs-mémoire de $2^{n+1}$ mots, ce qui résulte de l'égalité :

$$2^{\alpha + n} = [N - (2^\alpha - N)] 2^n + (2^\alpha - N) 2^{n + 1}$$

8

# 0 047 199

de démonstration immédiate. Dans cette égalité le terme entre crochets vérifie les inégalités :

$$0 < N - (2^\alpha - N) \leqslant 2^\alpha$$

et le terme entre parenthèses l'inégalité $2^\alpha - N \geqslant 0$ car $2^{\alpha-1} < N \leqslant 2^\alpha$. Cela signifie que la mémoire de $2^{\alpha+n}$ mots peut être partitionnée en $N - (2^\alpha - N)$ blocs de taille $2^n$ et en $(2^\alpha - N)$ blocs de taille $2^{n+1}$. D'une manière générale, on peut donc libérer $(2^\alpha - N)$ entrées supplémentaires.

Par ailleurs, lorsque N est différent de $2^\alpha$, la suite des échantillons intervenant dans la sommation de la partie non récursive présente des particularités. Le tableau III ci-après donne à titre d'exemple la suite des échantillons $x_k$ non nuls dans le cas où N = 3 et où l'ordre de la partie non récursive est égal à 7. Les échantillons nuls ne sont pas mentionnés pour simplifier. Le nombre de $x_k$ non nuls qui interviennent dans la sommation sur k est égal à 2 sauf une fois où il est égal à 3. Il est aisé de voir que, d'une façon générale, le nombre des $x_k$ non nuls est égal à K ou à K + 1 où K est défini par l'inégalité déjà mentionnée :

$$(K - 1) N + 2^\alpha - N \leqslant p < KN + 2^\alpha - N \qquad (6)$$

qui ne diffère de l'inégalité (9) que par l'introduction du terme $2^\alpha - N$ qui représente l'écart entre N et la puissance de 2 qui suit immédiatement. (Si $N = 2^\alpha$, cet écart est nul et l'on trouve la première condition). On peut voir également que les cas où les $x_k$ non nuls sont au nombre de K + 1, sont précisément au nombre de $2^\alpha - N$. Par exemple pour N = 3, on a $\alpha = 2$ et $2^\alpha - N = 1$ et K = 2 et il y a bien un cas où le nombre d'entrées à prendre en compte est égal à K + 1 = 3.

Le tableau IV donne, de la même manière, la suite des échantillons $x_k$ qui interviennent pour N = 5 et p = 7. On a alors $\alpha = 3$, $2^\alpha - N = 3$, K = 1 et il y a bien $2^\alpha - N = 3$ cas où le nombre d'entrées à prendre en compte est égal à K + 1 = 2.

Si l'on rapproche ces considérations sur le nombre d'entrées à prendre à compte de celles sur la nature des configurations binaires délivrées par le compteur on voit immédiatement que le nombre de cas où il faudra utiliser un registre supplémentaire (K + 1 registres au lieu de K) est précisément égal au nombre de configurations binaires délivrées par le compteur contenant un bit non significatif. Dans les tableaux III et IV les configurations binaires délivrées par le compteur ont été rangées à la partie inférieure de telle sorte que les configurations à bits non significatifs (lesquels sont encadrés) soient situées en regard des cas où le nombre de $x_k$ non nul est égal à K + 1.

L'invention propose alors d'adresser la mémoire non pas à la fois avec le bit susceptible d'être non significatif et avec le contenu du registre supplémentaire, mais soit avec le premier (lorsqu'il est significatif), soit avec le second, lorsque le bit en question n'est pas significatif, ce qui permet d'optimiser l'utilisation de la mémoire.

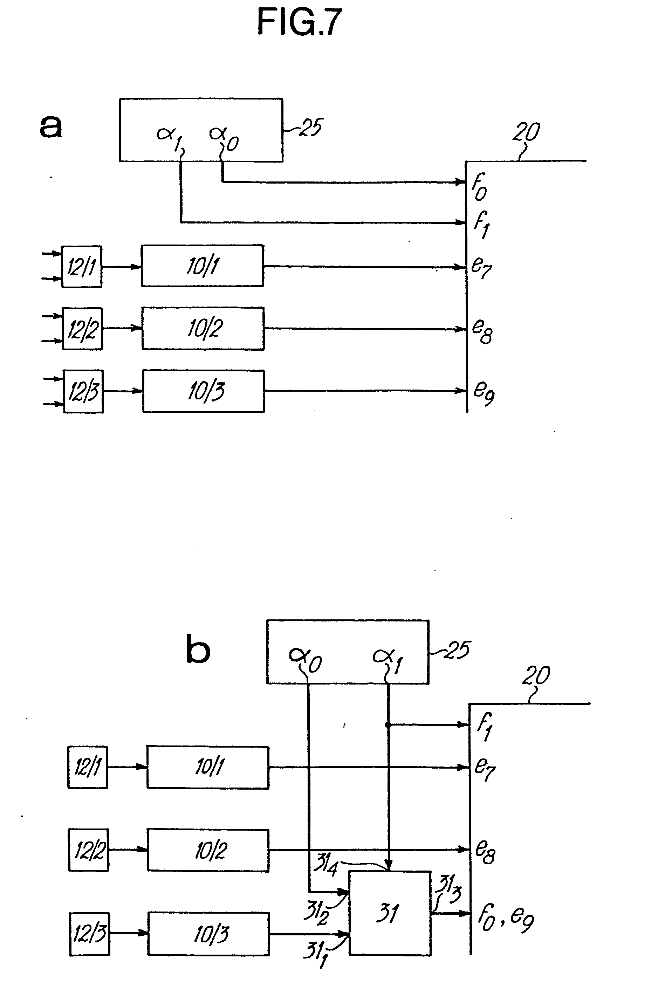

Cette variante est illustrée sur la figure 7 dans le cas où N = 3, $\alpha = 2$ et K = 2, ce qui correspond au tableau III. Au point de vue des fréquences d'échantillonnage il s'agit par exemple des valeurs 24 kHz et 8 kHz.

Sur la figure a, est représentée la solution qui consisterait à utiliser 3 registres série 10/1, 10/2, 10/3 associés à leur multiplexeur 12/1, 12/2, 12/3 comme décrit plus haut (les organes annexes ne sont pas représentés pour simplifier la figure). Ces trois registres sont reliés à 3 entrées d'adressage $e_7$, $e_8$ et $e_9$ de la mémoire 20. Par ailleurs, le compteur 25 a ses 2 sorties $\alpha_0$ et $\alpha_1$ reliées à deux entrées $f_0$ et $f_1$ de la mémoire. Ainsi qu'il a été expliqué plus haut, lorsque $\alpha_1$ est à 1, $\alpha_0$ n'est pas significatif et cette disposition laisserait la mémoire 20 mal utilisée. Pour y remédier on adopte la variante de la partie b qui diffère de la précédente par l'adjonction d'un multiplexeur 31 à deux entrées 31/1 et 31/2, une sortie 31/3 et une entrée de commande 31/4. L'entrée 31/1 est reliée au registre série supplémentaire 10/3, l'entrée 31/2 à la sortie $\alpha_0$ du compteur 25, la sortie 31/3 à une entrée ($f_0$, $e_9$) de la mémoire, et l'entrée de commande 31/4 à la sortie $\alpha_1$ du compteur. Lorsque $\alpha_1$ est à 1, c'est l'entrée 31/1 qui est reliée à la sortie 31/3 et lorsque $\alpha_1 = 0$ c'est l'entrée 31/2 qui est reliée à cette même sortie. Ainsi, l'entrée ($f_0/e_9$) de la mémoire est-elle reliée soit au registre supplémentaire 10/3 lorsque le bit $\alpha_0$ n'est pas significatif, soit à la sortie $\alpha_0$ lorsque le bit qu'elle délivre est significatif. La mémoire est alors totalement utilisée.

Cette disposition peut être utilisée de la même manière lorsque le facteur de multiplexage M des multiplexeurs (comme 26/1 à 26/5 de la figure 5, ou 28/1 à 28/3 de la figure 6) n'est pas égal à une puissance de 2. Alors, ceux des bits délivrés par le compteur 29 qui peuvent ne pas être significatifs seront multiplexés avec des entrées reliées à des registres. Par exemple, pour des multiplexeurs à 3 entrées (M = 3), on obtiendra à la sortie du compteur modulo 3 un bit $\beta_0$ non significatif lorsque $\beta_1$ sera à 1 et la sortie $\beta_0$ pourra être multiplexée avec un des registres.

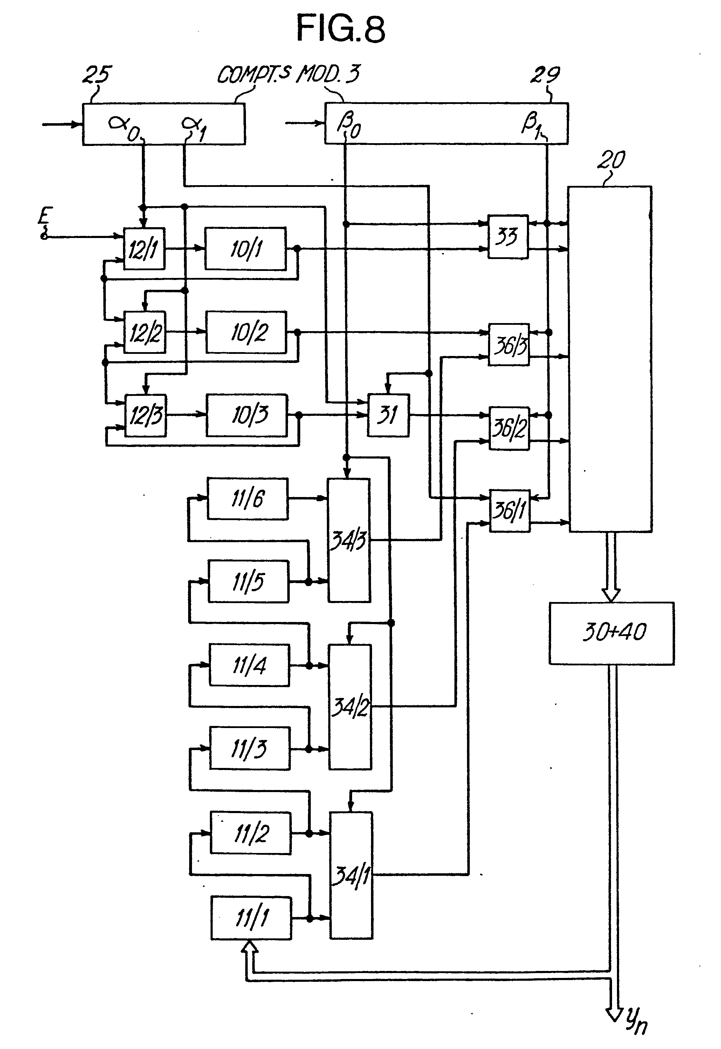

La figure 8 illustre un cas où toutes ces dispositions sont combinées et cela dans le cas où M = N = 3 ; les compteurs 25 et 29 sont alors modulo 3 et les bits $\alpha_0$ et $\beta_0$ sont non significatifs lorsque $\alpha_1$ et $\beta_1$ sont à 1. Les multiplexeurs à 3 entrées sont en réalité obtenus par 2 étages de multiplexage à 2 entrées, respectivement 34/1, 34/2, 34/3 et 36/1, 36/2, 36/3. Le multiplexeur à deux entrées et une sortie 33 permet de multiplexer la sortie du registre 10/1 avec la sortie $\beta_0$ du compteur 29 qui n'est pas significative quand $\beta_1$ égale 1. On a encore dans le cas illustré p = 6 et q = 6, donc K = 2. Il y a donc K + 1 = 3 registres-série 10/1, 10/2, 10/3 contenant les entrées $x_k$ et 6 registres 11/1 à 11/6 contenant les sorties $y_n$. Le registre 10/3 est multiplexé avec le bit $\alpha_0$ de faible poids du compteur 25. La convention adoptée pour les

9

multiplexeurs est celle déjà utilisée, à savoir que l'entrée supérieure est reliée à la sortie lorsque le signal de commande est à 1. L'utilisation des multiplexeurs 34/1, 34/2, 34/3, 33, 36/1, 36/2, 36/3 permet de réduire la taille de la mémoire de $2^{10} = 1\,024$ mots de m bits à $2^5 = 32$ mots de m bits. Sans le multiplexeur 31, et sans les multiplexeurs de la liste précédente, la taille de la mémoire aurait été de $2^{11} = 2\,048$ mots de m bits. L'utilisation des multiplexeurs multiplie par 3 la fréquence de calcul.

Ces dispositions peuvent encore être combinées avec le cas où les entrées sont bloquées P fois sur N. Il faut alors modifier la relation définissant K en :

$$(K - 1) N + 2^\alpha - N \leqslant p + P - 1 < KN + 2^\alpha - N \qquad (6)$$

Tableau I

| k | j = 0 | j = 1 | j = 2 | j = 3 |
|---|---|---|---|---|
| 0 | $x_{tN} \neq 0$ | $x_{tN+1} = 0$ | $x_{tN+2} = 0$ | $x_{tN+3} = 0$ |
| 1 | $x_{tN-1} = 0$ | $x_{tN} \neq 0$ | $x_{tN+1} = 0$ | $x_{tN+2} = 0$ |
| 2 | $x_{tN-2} = 0$ | $x_{tN-1} = 0$ | $x_{tN} \neq 0$ | $x_{tN+1} = 0$ |
| 3 | $x_{tN-3} = 0$ | $x_{tN-2} = 0$ | $x_{tN-1} = 0$ | $x_{tN} \neq 0$ |
| 4 | $x_{tN-4} \neq 0$ | $x_{tN-3} = 0$ | $x_{tN-2} = 0$ | $x_{tN-1} = 0$ |
| 5 | $x_{tN-5} = 0$ | $x_{tN-4} = 0$ | $x_{tN-3} \neq 0$ | $x_{tN-2} = 0$ |
| 6 | $x_{tN-6} = 0$ | $x_{tN-5} = 0$ | $x_{tN-4} \neq 0$ | $x_{tN-3} = 0$ |
| coefficients | $a_0, a_4$ | $a_1, a_5$ | $a_2, a_6$ | $a_3$ |

(Voir Tableau p. suivantes)

Tableau II

| k | j = 0 | j = 1 | j = 2 | j = 3 |
|---|---|---|---|---|
| 0 | $x_{tN} \neq 0$ | $x_{tN+1} = x_{tN}$ | $x_{tN+2} = 0$ | $x_{tN+3} = 0$ |
| 1 | $x_{tN-1} = 0$ | $x_{tN} \neq 0$ | $x_{tN+1} = x_{tN}$ | $x_{tN+2} = 0$ |
| 2 | $x_{tN-2} = 0$ | $x_{tN-1} = 0$ | $x_{tN} \neq 0$ | $x_{tN+1} = x_{tN}$ |
| 3 | $x_{tN-3} = x_{tN-4}$ | $x_{tN-2} = 0$ | $x_{tN-1} = 0$ | $x_{tN} \neq 0$ |
| 4 | $x_{tN-4} \neq 0$ | $x_{tN-3} = x_{tN-4}$ | $x_{tN-2} = 0$ | $x_{tN-1} = 0$ |
| 5 | $x_{tN-5} = 0$ | $x_{tN-4} \neq 0$ | $x_{tN-3} = x_{tN-4}$ | $x_{tN-2} = 0$ |
| 6 | $x_{tN-6} = 0$ | $x_{tN-5} = 0$ | $x_{tN-4} \neq 0$ | $x_{tN-3} = x_{tN-4}$ |
| coefficients | $a_0, a_3 + a_4$ | $(a_0 + a_1), (a_4 + a_5)$ | $(a_1 + a_2), (a_5 + a_6)$ | $(a_2 + a_3), a_6$ |

Tableau III

| k | $j = 0$ | $j = 1$ | $j = 2$ |
|---|---|---|---|
| 0 | $x_{tN}$ | | |
| 1 | | $x_{tN}$ | |
| 2 | | | $x_{tN}$ |
| 3 | $x_{tN-3}$ | | |
| 4 | | $x_{tN-3}$ | |
| 5 | | | $x_{tN-3}$ |
| 6 | $x_{tN-6}$ | | |
| Nombre de $x_k$ non nuls | 3 | 2 | 2 |
| Configuration binaire | 1 $\boxed{0}$ | 0 0 | 0 1 |

Tableau IV

| k | $j = 0$ | $j = 1$ | $j = 2$ | $j = 3$ | $j = 4$ |
|---|---|---|---|---|---|
| 0 | $x_{tN}$ | | | | |
| 1 | | $x_{tN}$ | | | |
| 2 | | | $x_{tN}$ | | |
| 3 | | | | $x_{tN}$ | |
| 4 | | | | | $x_{tN}$ |
| 5 | $x_{tN-5}$ | | | | |
| 6 | | $x_{tN-5}$ | | | |
| 7 | | | $x_{tN-5}$ | | |
| Nombre de $x_k$ non nuls | 2 | 2 | 2 | 1 | 1 |
| Configuration binaire du compteur | $\boxed{0}$ 1 0 | $\boxed{0}$ 1 1 | 1 0 $\boxed{0}$ | 0 0 0 | 0 0 1 |

**Revendications**

1. Filtre numérique récursif de suréchantillonnage en arithmétique distribuée, comprenant une partie récursive d'ordre q constituée d'un registre à chargement parallèle (11/1) et de q − 1 registres-série (11/2, 11/3, ...) ces q registres étant circulants, c'est-à-dire reliés en cascade, une partie non récursive d'ordre p constituée de registres-série, une mémoire (20) divisée en N blocs-mémoire contenant chacun un jeu de quantités précalculées caractéristiques du filtrage à effectuer, un compteur (25) modulo N à $\alpha$ sorties, la mémoire (20) possédant d'une part $\alpha$ entrées ($f_0$, $f_1$ ... $f_{\alpha-1}$) d'adressage des différents blocs reliées aux $\alpha$ sorties du compteur et, d'autre part, des entrées ($e_1$, $e_2$, ...) d'adressage à l'intérieur d'un bloc reliées aux sorties des registres des parties récursive et non récursive, un additionneur-soustracteur (30) relié à la mémoire, un registre-accumulateur (40) dont l'entrée est reliée à l'additionneur-soustracteur et la sortie au registre (11/1) à chargement parallèle, et à l'additionneur-soustracteur, les signaux d'entrée de la partie non récursive pouvant être bloqués P fois sur N, une horloge de fréquence $f_S$ commandant la sortie des signaux du registre accumulateur et leurs entrées dans la partie récursive et actionnant le compteur, une horloge (50) de fréquence $rf_S$ commandant le décalage des différents registres, si r est la longueur commune aux différents registres série, la fréquence $f_S$ étant égale à $Nf_E$ où N est un entier, et $f_E$ la fréquence d'échantillonnage des signaux à l'entrée du filtre et $f_S$ la fréquence en sortie du filtre, caractérisé en ce que la partie non récursive ne comprend que K registres-série, K étant un entier défini par la double inégalité :

$$(K - 1) N + 2^\alpha - N \leqslant p + P - 1 < KN + 2^\alpha - N$$

et en ce qu'il comprend des moyens de commutation aptes à rendre ces K registres recirculants, c'est-à-dire bouclés sur eux-mêmes, N − 1 fois sur N et circulants, c'est-à-dire reliés en cascade les uns aux autres, une fois sur N, ces moyens de commutation étant commandés par les sorties du compteur.

2. Filtre selon la revendication 1, caractérisé en ce que les moyens de commutation sont constitués par K multiplexeurs (12/1, 12/2, ...) à deux entrées de signal ($m_1$, $m_2$), une sortie ($m_3$) et une entrée de commande ($m_4$), la seconde entrée ($m_2$) de chaque multiplexeur étant reliée à la sortie du registre-série auquel il est associé, la première entrée ($m_1$) étant reliée à la sortie du registre qui précède, sauf pour le premier dont l'entrée est reliée à une entrée générale des signaux à traiter, l'entrée de commande des multiplexeurs étant actionnée à partir du compteur de telle sorte que, lorsque le contenu de ce compteur est à son maximum, la sortie ($m_3$) de chaque multiplexeur soit reliée à la première entrée ($m_1$), ce qui rend les registres circulants, et lorsque le contenu du compteur est différent de ce maximum, la sortie ($m_3$) soit reliée à la seconde entrée ($m_2$), ce qui rend les registres recirculants.

3. Filtre selon l'une quelconque des revendications 1 et 2, caractérisé en ce que N n'étant pas égal à la puissance $\alpha$ de 2, la partie non récursive comprend un $(K + 1)^{ème}$ registre série (10/3) multiplexé avec une sortie ($\alpha_0$) du compteur (25) modulo N susceptible de délivrer un bit non significatif pour l'adressage de la mémoire.

4. Filtre selon l'une quelconque des revendications 1 à 3, caractérisé en ce que la mémoire est précédée de multiplexeurs à M entrées reliées aux registres et éventuellement aux sorties du compteur modulo N, ces multiplexeurs étant commandés par un compteur modulo M (29) dont les sorties ($\beta_0$, $\beta_1$) sont reliées à des entrées d'adressage de la mémoire.

5. Filtre selon la revendication 4, caractérisé en ce que M n'étant pas égal à la puissance $\beta$ de 2, il comprend $2^\beta - M$ multiplexeurs à 2 entrées dont l'une est reliée à la sortie ($\beta_0$) du compteur (29) modulo M susceptible de délivrer un bit non significatif pour l'adressage de la mémoire.

**Claims**

1. Recursive digital filter for super-sampling using distributed arithmetic, comprising a recursive part of order q constituted by a parallel loading register (11/1) and q − 1 series registers (11/2, 11/3, ...) said q registers being circulating, i.e. connected in cascade, a non-recursive part of order p constituted by series registers, a memory (20) divided into N memory-blocks each containing a precalculated set of values characteristic of the filtering to be carried out, a counter modulo N (25) having $\alpha$ outputs, the memory (20) having on the one hand $\alpha$ inputs ($f_0$, $f_i$ ... $f_{\alpha-1}$) for addressing the different blocks connected to the $\alpha$ outputs of the counter, and, on the other hand, inputs ($e_1$, $e_2$ ...) for addressing the interior of a block, connected to the outputs of the registers of the recursive and non-recursive parts, an up-down counter (30) connected to the memory, a register-accumulator (40) whose input is connected to the up-down counter and whose output is connected to the parallel-loading register (11/1) and to the up-down counter, the input signals of the non-recursive part being blocked P/N times, a timer of frequency $f_s$ commanding the output of signals from the register-accumulator, and the input thereof into the recursive part, and actuating the counter, a timer (50) of frequency $rf_s$ commanding shifting of the different registers, if r is the common length of the different series registers, the frequency $f_s$ being equal to $Nf_e$ where N is an integer, $f_E$ is the sampling frequency for signals at the input of the filter and $f_s$ the frequency at the output of the filter, characterized in that the non-recursive part comprises only K series registers, K being an integer defined by the double inequality.

$$(K - 1) N + 2^\alpha - N \leqslant p + P - 1 < KN + 2^\alpha - N$$

and in that it comprises commutation means adapted to switch the K registers between a recirculating mode i.e. looped on themselves $(N - 1)/N$ times, and a circulating mode, i.e. connected to one another in cascade $1/N$ times, said commutation means being commanded by the outputs of the counter.

2. Filter according to Claim 1, characterized in that the commutation means comprise K multiplexers $(12/1, 12/2, ...)$ having two signal inputs $(M_1, M_2)$, one output $(M_3)$ and a command input $(M_4)$, the second input $(M_2)$ of each multiplexer being connected to the output of the series register with which it is associated, the first input $(M_1)$ being connected to the output of the preceding register, except for the first, whose input is connected to a general input for signals to be processed, the command input of the multiplexers being actuated by the counter, whereby, when the content of the counter is at its maximum, the output $(M_3)$ of each multiplexer is connected to the first input $(M_1)$, thereby putting the registers in the circulating mode, and, when the content of the counter differs from the maximum, the output $(M_3)$ is connected to the second input $(M_2)$, thereby putting the registers in the recirculating mode.

3. Filter according to either of Claims 1 and 2, characterized in that the non-recursive part comprises a $(K + 1)$th series register $(10/3)$ multiplexed with an output $(\alpha_0)$ of the counter modulo N $(25)$ capable of delivering a non-significant bit for addressing the memory, N not being equal to the power $\alpha$ of 2.

4. Filter according to any one of Claims 1 to 3, characterized in that the memory is preceded by multiplexers having M inputs connected to the registers and ultimately to the outputs of the counter modulo N, said multiplexers being commanded by a counter modulo M $(29)$ whose outputs $(\beta_0, \beta_1)$ are connected to the address inputs of the memory.

5. Filter according to Claim 4, characterized in that it comprises $2^\beta - M$ multiplexers having two inputs, one of which is connected to the output $(\beta_0)$ of counter modulo M $(29)$ capable of delivering a non-significant bit for addressing the memory, M not being equal to the power $\beta$ of 2.


## Ansprüche

1. Rekursives, interpolierendes Digitalfilter mit verteilter Arithmetik, umfassend einen rekursiven Teil von der Ordnung q, der aus einem parallel einzuschreibenden Register $(11/1)$ und aus $q - 1$ Reihenregistern $(11/2, 11/3, ...)$ besteht, wobei diese q-Register umlaufend, d. h. stufenweise verbunden sind, einen nichtrekursiven Teil von der Ordnung p, der von Reihenregistern gebildet ist, einen Speicher $(20)$, der in N-Speicherblöcke unterteilt ist, von denen jeder einen Satz von für die durchzuführende Filterung charakteristischen, vorberechneten, Werten enthält, einen Zähler $(25)$ Modulo N mit $\alpha$ Ausgängen, wobei der Speicher $(20)$ einerseits $\alpha$ Adresseneingänge $(f_0, f_1 ... f_{\alpha-1})$ der verschiedenen Blöcke, die mit $\alpha$ Ausgängen des Zählers verbunden sind, und andererseits innerhalb eines Blockes Adressierungseingänge $(e_1, e_2 ...)$ aufweist, die mit den Ausgängen der Register des rekursiven und des nichtrekursiven Teils verbunden sind, ein mit dem Speicher verbundenes Addier-Subtrahierwerk $(30)$, ein Akkumulatorregister $(40)$, dessen Eingang mit dem Addier-Subtrahierwerk und dessen Ausgang mit dem parallel einzuschreibender Register $(11/1)$ und dem Addier-Subtrahierwerk verbunden ist, wobei die Eingangssignale des nichtrekursiven Teils P-mal auf N blockiert werden können, einen Taktgeber mit der Frequenz $f_S$, der den Ausgang der Signale des Akkumulatorregisters und ihre Eingänge in den rekursiven Teil steuert und den Zähler betätigt, einen Taktgeber $(50)$ mit der Frequenz $rf_S$, der die Verschiebung der verschiedenen Register steuert, wenn r die gemeinsame Länge der verschiedenen Reihenregister ist, wobei die Frequenz $f_S$ gleich ist $Nf_E$ mit N einer ganzen Zahl und $f_E$ die Schaltfrequenz der Signale am Eingang des Filters und $f_S$ die Frequenz am Ausgang des Filters bedeuten, dadurch gekennzeichnet, daß der nichtrekursive Teil nur K Reihenregister umfaßt, wobei K eine ganze, durch die doppelte Ungleichung festgelegte Zahl ist :

$$(K - 1) N + 2^\alpha - N \leqslant p + P - 1 < KN + 2^\alpha - N$$

und daß Umschaltmittel vorgesehen sind, durch die diese K Register $N - 1$-mal auf N rezirkulierend, d. h. mit sich selbst zur Schleife geschaltet, und einmal auf N umlaufend, d. h. miteinander stufenförmig verbunden, gemacht werden, wobei diese Umschaltmittel durch die Ausgänge des Zählers steuerbar sind.

2. Filter nach Anspruch 1, dadurch gekennzeichnet, daß die Umschaltmittel gebildet sind von K-Multiplexern $(12/1, 12/2...)$ mit zwei Signaleingängen $(m_1, m_2)$, einen Ausgang $(m_3)$ und einem Steuereingang $(m_4)$, daß der zweite Eingang $(m_2)$ jedes Multiplexers mit dem Ausgang des Reihenregisters verbunden ist, dem er zugeordnet ist, daß der erste Eingang $(m_1)$ mit dem vorhergehenden Register verbunden ist, mit Ausnahme für den ersten, dessen Eingang mit einem allgemeinen Eingang für die zu behandelnden Signale verbunden ist, daß der Steuereingang der Multiplexer mittels des Zählers derart betätigbar ist, daß, wenn der Inhalt dieses Zählers sein Maximum erreicht hat, der Ausgang $(m_3)$ eines jeden Multiplexers mit dem ersten Eingang $(m_1)$ verbunden ist, wodurch die Register umlaufend werden, und wenn der Inhalt des Zählers von diesem Maximum verschieden ist, der Ausgang ($m_3$) mit dem zweiten Eingang ($m_2$) verbunden wird, wodurch die Register rezirkulierend werden.

3. Filter nach Anspruch 1 oder 2, dadurch gekennzeichnet, daß N ungleich der Potenz $\alpha$ von 2 ist, und daß der nichtrekursive Teil ein (K + 1)-tes Reihenregister (10/3) umfaßt, welches mit einem Ausgang ($\alpha_0$) des Zählers (25) Modulo N gemultiplext wird, der für die Adresse des Speichers ein nichtsignifikantes Bit liefern kann.

4. Filter nach irgendeinem der Ansprüche 1 bis 3, dadurch gekennzeichnet, daß dem Speicher Multiplexer mit M-Eingängen vorausgehen, die mit den Registern und gegebenenfalls den Ausgängen des Zählers Modulo N verbunden sind, wobei diese Multiplexer von einem Zähler Modulo M (29) gesteuert werden, dessen Ausgänge ($\beta_0$, $\beta_1$) mit den Adresseneingängen des Speichers verbunden sind.

5. Filter nach Anspruch 4, dadurch gekennzeichnet, daß M ungleich der Potenz $\beta$ von 2 ist und das Filter $2^\beta$ − M Multiplexer mit zwei Eingängen umfaßt, von denen einer mit dem Ausgang ($\beta_0$) des Zählers (29) Modulo M verbunden ist, der für die Adresse des Speichers ein nichtsignifikantes Bit liefern kann.

# FIG.1

## CODAGE

EA $\longrightarrow$ | RC | $\longrightarrow$ | 2048kHz | $\xrightarrow{\text{1bit 2048kHz}}$ | | $\xrightarrow{\text{13 bits 16kHz}}$ | | $\xrightarrow{\text{13 bits 8kHz}}$ | A | $\longrightarrow$ (MIC) SN8bits 8kHz

1    2    3    4    5

## DÉCODAGE

EN $\longrightarrow$ | A | $\longrightarrow$ | 32 kHz | $\xrightarrow{\text{13 bits 32kHz}}$ | 2048kHz | $\xrightarrow{\text{1bit 2048 kHz}}$ | RC | $\longrightarrow$ SA

8bits 8kHz    6    7    8    9

0 047 199

# FIG.2

REG.SER. r bits

$u_1$ → 10/1 → 1

$u_2$ → 10/2 → 2

$u_3$ → 10/3 → 3

MÉMOIRE

$2^p$ mots de m bits ～20

$u_p$ → 10/p → p

m bits

30～ ADD. SOUS.

40 REG. ACC.

$rf_E$

50

HORLOGE

$v$

# FIG.3

# FIG.4

FIG.5

0 047 199

FIG.6

# FIG.7

a

b

# FIG.8

25    COMPT.S MOD. 3    29

20

$\alpha_0$    $\alpha_1$    $\beta_0$    $\beta_1$

E

12/1    10/1    33

12/2    10/2    36/3

12/3    10/3    31    36/2

11/6    34/3    36/1

11/5

11/4    34/2

11/3

11/2    34/1

11/1

30+40

$y_n$